(19) Europäisches Patentamt
European Patent Office
Office européen des brevets

(11) **EP 4 439 175 A2**

(12) **EUROPEAN PATENT APPLICATION**

(43) Date of publication:
**02.10.2024 Bulletin 2024/40**

(51) International Patent Classification (IPC):
**G03F 1/38** *(2012.01)*

(21) Application number: **24162675.3**

(22) Date of filing: **11.03.2024**

| (84) Designated Contracting States:<br>**AL AT BE BG CH CY CZ DE DK EE ES FI FR GB GR HR HU IE IS IT LI LT LU LV MC ME MK MT NL NO PL PT RO RS SE SI SK SM TR**<br>Designated Extension States:<br>**BA**<br>Designated Validation States:<br>**GE KH MA MD TN**<br><br>(30) Priority: **23.03.2023 JP 2023046629** | (71) Applicant: **Canon Kabushiki Kaisha**<br>**Tokyo 146-8501 (JP)**<br><br>(72) Inventor: **KOBAYASHI, Toru**<br>**Tokyo 146-8501 (JP)**<br><br>(74) Representative: **Canon Europe Limited**<br>**European Intellectual Property Group**<br>**4 Roundwood Avenue**<br>**Stockley Park**<br>**Uxbridge UB11 1AF (GB)** |

(54) **ORIGINAL, METHOD OF DETERMINING PATTERN OF ORIGINAL, AND METHOD OF EXPOSING**

(57) An original includes a pattern formed for use in exposure of a photosensitive material disposed on an upper side of a multilayer film provided on a substrate, wherein the pattern includes a main pattern and an auxiliary pattern disposed at a position separated by a predetermined interval from the main pattern, and wherein the auxiliary pattern suppresses irregularities on an inclined surface of a sidewall portion of the photosensitive material on which the main pattern is formed.

FIG.4

**Description**

BACKGROUND OF THE INVENTION

Field of the Invention

The present invention relates to an original, a method of determining a pattern of the original, and an exposure method.

Description of the Related Art

In a process of manufacturing a semiconductor device, a structure having a stepped shape is formed in a multilayer film obtained by alternately stacking films having different dielectric constants in some cases. Japanese Patent Application Laid-Open No. 2014-36148 discusses a method of forming a structure having a stepped shape in a multilayer film by providing a resist on the multilayer film and alternately repeating etching of the multilayer film and reduction (trimming or slimming) of a width of the resist.

Step surface widths of steps of the stepped shape formed in the multilayer film are desirably not different from each other. Irregularities may occur on inclined surfaces of sidewall portions of the resist, and the widths of the multilayer film to be exposed when the width of the resist is reduced may be different from each other due to the irregularities. When the widths of the multilayer film to be exposed are different from each other, widths of the multilayer film to be etched when the etching of the multilayer film is repeated are different from each other, and the step surface widths of the steps of the stepped shape are accordingly different from each other.

SUMMARY OF THE INVENTION

The present invention is directed to an original that can suppress irregularities on inclined surfaces of sidewall portions of a resist used for forming a stepped shape in a multilayer film.

According to a first aspect of the present invention, there is provided an original as specified in claims 1 to 7. According to a second aspect of the present invention, there is provided method of determining as specified in claims 8 and 9. According to a third aspect of the present invention, there is provided a method of exposing as specified in claim 10.

Further features of the present invention will become apparent from the following description of exemplary embodiments with reference to the attached drawings.

BRIEF DESCRIPTION OF THE DRAWINGS

Fig. 1 is a schematic view illustrating a configuration of an exposure apparatus according to a first exemplary embodiment.

Figs. 2A to 2F are schematic views illustrating formation of a stepped shape in a multilayer film.

Figs. 3A to 3F are schematic views illustrating formation of a stepped shape in a multilayer film in a case where inclined surfaces of sidewall portions of a resist have irregularities.

Fig. 4 illustrates an example of an original according to the first exemplary embodiment.

Figs. 5A and 5B each illustrate a simulation result of an inclined surface of each sidewall portion of the resist.

Fig. 6 is a flowchart illustrating an example of a method of determining a pattern of the original according to the first exemplary embodiment.

Figs. 7A and 7B each illustrate another example of the original according to the first exemplary embodiment.

Figs. 8A to 8F illustrate examples of a pattern of an original and a resist shape according to a second exemplary embodiment.

Fig. 9 is a flowchart illustrating a method of manufacturing an article according to a third exemplary embodiment.

DESCRIPTION OF THE EMBODIMENTS

Some exemplary embodiments of the present invention are described below with reference to the drawings. The following exemplary embodiments do not limit the invention set forth in the claims. Although a plurality of features is described in the exemplary embodiments, all of the plurality of features is not necessarily essential for the invention, and the plurality of features may be freely combined. Further, in the drawings, the same or similar components are denoted by the same reference numerals, and repetitive description is omitted.

In the present specification and drawings, directions are basically represented by an XYZ coordinate system in which a vertical direction is a Z axis, a horizontal plane perpendicular to the vertical direction is an XY plane, and axes are orthogonal to each other. However, in a case where the XYZ coordinate system is illustrated in each drawing, priority is given to the illustrated coordinate system.

Hereinafter, a specific configuration is described in each of the exemplary embodiments.

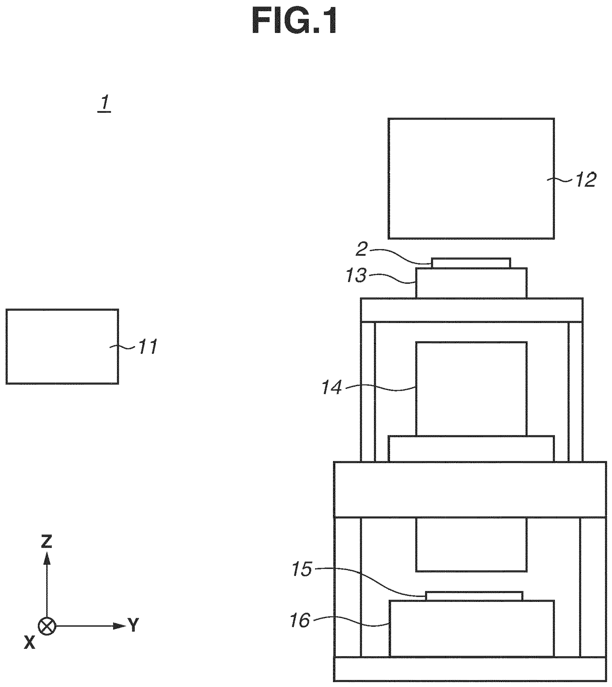

Fig. 1 is a schematic view illustrating a configuration of an exposure apparatus 1 according to a first exemplary embodiment. In the present exemplary embodiment, the exposure apparatus 1 is a projection exposure apparatus that exposes a substrate by projecting a pattern of an original (mask or reticle) onto the substrate through a projection optical system by a step-and-repeat method or a step-and-scan method.

The exposure apparatus 1 includes an illumination optical system 12 that applies light, a projection optical system 14, an original stage 13 that holds an original 2, a stage 16 that is movable in an XY direction while holding a substrate 15, and a control unit 11. The original 2 has a pattern (e.g., circuit pattern) that is made of chromium and is to be transferred to, for example, a surface of quartz glass. The substrate 15 is made of, for example, monocrystalline silicon, and a resist (photosensitive material) is applied to a surface of the substrate 15. The control unit 11 controls components in the exposure apparatus 1.

In the exposure apparatus 1, exposure light from a light source (not illustrated) illuminates the original 2 held by the original stage 13 through the illumination optical system 12. The light having passed through the original 2 is shone on the substrate 15 through the projection optical system 14. At this time, light from the pattern formed on the original 2 forms an image on the surface of the substrate 15. In this way, the exposure apparatus 1 exposes a shot area on the substrate 15, and similarly performs exposure on each of a plurality of shot areas.

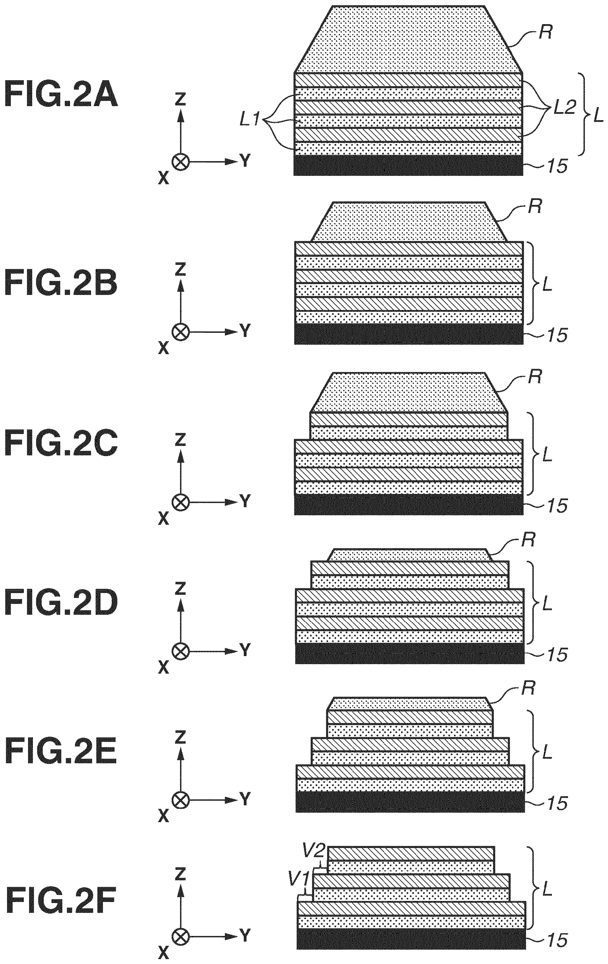

Figs. 2A to 2F are schematic views illustrating formation of a stepped shape in a multilayer film. Fig. 2A illustrate an example in which a multilayer film L is formed on the substrate 15, and a resist (photosensitive material) R is disposed on a +Z direction side of the multilayer film L. The multilayer film L is obtained by alternately stacking first films L1 and second films L2 different in dielectric constant from each other. Further, inclined surfaces of sidewall portions of the resist R disposed in Fig. 2A do not have irregularities.

First, as illustrated in Fig. 2B, the resist R is trimmed to reduce a width of the resist R. As a result, a part of the multilayer film L on the +Z direction side is exposed without being covered with the resist R. In this state, as illustrated in Fig. 2C, etching is performed on the multilayer film L. At this time, a part of the multilayer film L covered with the resist R is not etched because of being protected by the resist R. Thus, only the exposed part of the multilayer film L is etched, and one step of the stepped shape is formed.

Next, as illustrated in Fig. 2D, the resist R is further trimmed. As a result, the width of the resist R is further reduced, and an area of the exposed part of the multilayer film L on the +Z direction side is increased. In this state, as illustrated in Fig. 2E, etching is performed on the multilayer film L. As a result, only the exposed part of the multilayer film L is etched, and another one step of the stepped shape is further formed. As a result, the stepped shape having three levels of height is formed in the multilayer film L. Finally, as illustrated in Fig. 2F, the resist R is removed. The stepped shape can be formed in the multilayer film L in the above-described manner. In the example in Figs. 2A to 2F, the inclined surfaces of the sidewall portions of the disposed resist R do not have irregularities. Therefore, a difference between step surface widths of the steps of the stepped shape can be reduced. More specifically, in Fig. 2F, step surface widths V1 and V2 can be made equal to each other. Reducing the difference between the step surface widths of the steps of the stepped shape is equivalent to forming the step surface widths of the steps of the stepped shape to be within a range (allowable range) set by a user.

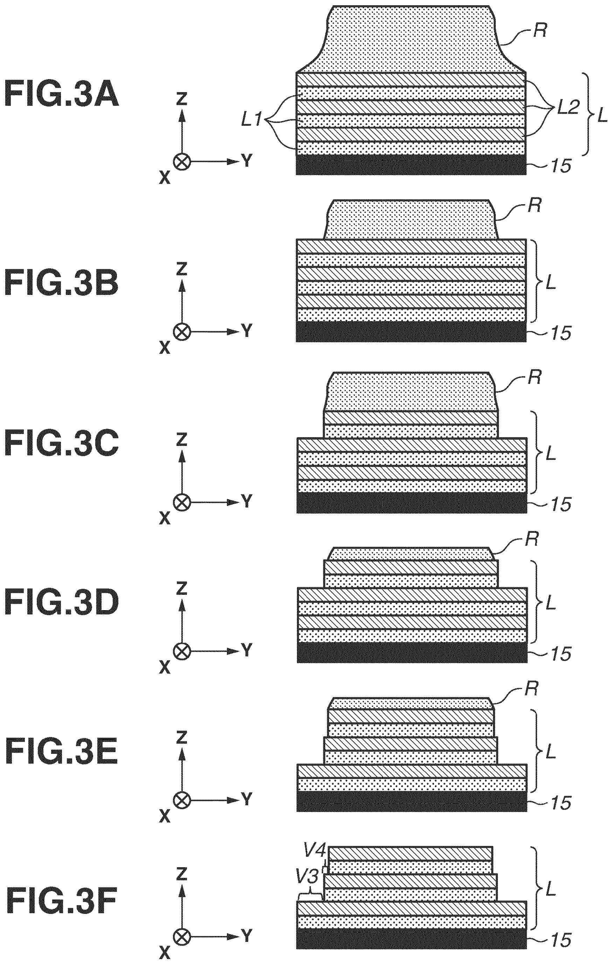

Figs. 3A to 3F are schematic views illustrating formation of the stepped shape in the multilayer film in a case where the inclined surfaces of the sidewall portions of the resist R have irregularities. The inclined surfaces of the sidewall portions of the resist R disposed in Fig. 3A have irregularities. First, as illustrated in Fig. 3B, the resist R is trimmed to reduce the width of the resist R. As a result, a part of the multilayer film L on the +Z direction side is exposed without being covered with the resist R. In this state, as illustrated in Fig. 3C, etching is performed on the multilayer film L. At this time, a part of the multilayer film L covered with the resist R is not etched because of being protected by the resist R. Thus, only the exposed part of the multilayer film L is etched, and one step of the stepped shape is formed.

Next, as illustrated in Fig. 3D, the resist R is further trimmed. As a result, the width of the resist R is further reduced, and an area of the exposed part of the multilayer film L on the +Z direction side is increased. In this state, as illustrated in Fig. 3E, etching is performed on the multilayer film L. As a result, only the exposed part of the multilayer film L is etched, and another one step of the stepped shape is further formed. As a result, the stepped shape having three levels of height is formed in the multilayer film L. Finally, as illustrated in Fig. 3F, the resist R is removed. The stepped shape can be formed in the multilayer film L in the above-described manner. In the example in Figs. 3A to 3F, the inclined surfaces of the sidewall portions of the disposed resist R have irregularities. Therefore, the step surface widths of the steps of the stepped shape are different from each other. More specifically, in Fig. 3F, step surface widths V3 and V4 cannot be made equal to each other. In other words, as can be seen from Figs. 2A to 2F and Figs. 3A to 3F, to reduce the difference between the step surface widths of the steps of the stepped shape, it is necessary to suppress irregularities on the inclined surfaces of the sidewall portions of the resist R. The present exemplary embodiment discusses an original that can suppress irregularities on the inclined surfaces of the sidewall portions of the resist R.

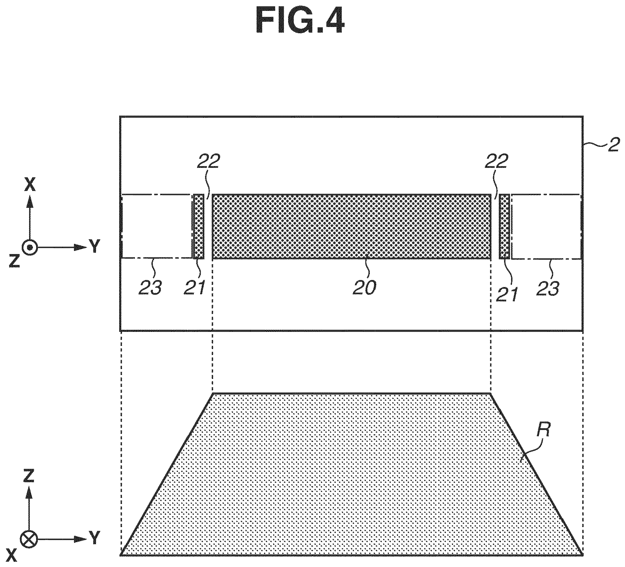

Fig. 4 illustrates an example of the original 2 according to the present exemplary embodiment. The original 2 includes a main pattern 20 through which the resist R is to be exposed, and auxiliary patterns 21 at positions that are each separated by an interval 22 (predetermined interval) from the main pattern 20 and that correspond to the inclined surfaces of the sidewall portions of the resist R. The auxiliary patterns 21 are provided to suppress irregularities on the inclined surfaces of the sidewall portions of the resist R. Areas 23 on sides opposite to respective intervals 22 with the corresponding auxiliary patterns 21 in between are at positions corresponding to the inclined surfaces of the sidewall portions of the resist R. The resist R is exposed using the original 2 in which the auxiliary patterns 21 and the intervals 22 are appropriately set, which makes it possible to suppress irregularities on the inclined surfaces of the sidewall portions of the resist R and to form the inclined surfaces of the sidewall portions of the resist R in desired shapes.

The pattern of the original 2 according to the present exemplary embodiment is determined based on information on the main pattern 20 and information on the desirable inclined surfaces of the sidewall portions of the resist R. In addition to the above-described information, the pattern of the original 2 according to the present exemplary embodiment may be determined based on at least one of an exposure condition, exposure characteristics of the resist R, and a film thickness of the resist R. Determination of the pattern of the original 2 is specifically synonymous with determination of a positional relationship between the main pattern 20 and the auxiliary patterns 21, determination of shapes of the auxiliary patterns 21, or determination of lengths of the intervals 22. In other words, the auxiliary patterns 21 of the original 2 according to the present exemplary embodiment are provided at positions based on the above-described information.

The information on the main pattern 20 includes, for example, a line width of the main pattern 20, a transmittance of the main pattern 20, and a position of the main pattern 20 on the original 2. The exposure condition includes, for example, a wavelength of light from the light source, wavelength characteristics of the light from the light source, a numerical aperture of the projection optical system 14 on an image plane side, light intensity distribution formed on a pupil plane of the projection optical system 14, a necessary exposure amount, and a focus. The exposure characteristics of the resist R include, for example, a degree of optical absorption of the resist R, a photodecomposition rate of the resist R, and a refractive index of the resist R.

A suitable example of the auxiliary patterns 21 according to the present exemplary embodiment is described. For example, in a case where a maximum thickness (length in Z direction) t (nm) of the resist R is thick as represented by an inequality (1), satisfying one or both of inequalities (2) and (3) makes it possible to suppress irregularities on the inclined surfaces of the sidewall portions of the resist R.

When a ratio of the maximum thickness (length in Z direction) t (nm) of the resist R and a width (length in Y direction) w (nm) of each of the auxiliary patterns 21 is set as represented by the inequality (2), it is possible to suppress irregularities on the inclined surfaces of the sidewall portions of the resist R. More specifically, the width (length in Y direction) w (nm) of each of the auxiliary patterns 21 is set to 0.028 times (2.8%) or less of the maximum thickness (length in Z direction) t (nm) of the resist R.

When a ratio of the maximum thickness (length in Z direction) t (nm) of the resist R and a width (length in Y direction) s (nm) of each of the intervals 22 is set as represented by the inequality (3), it is possible to suppress irregularities on the inclined surfaces of the sidewall portions of the resist R. More specifically, the width (length in Y direction) s (nm) of each of the intervals 22 is set to 0.028 times (2.8%) or less of the maximum thickness (length in Z direction) t (nm) of the resist R. Although a case where both the inequality (2) and the inequality (3) are satisfied is the most desirable, an effect of suppressing irregularities on the inclined surfaces of the sidewall portions of the resist R is high even in a case where only the inequality (3) is satisfied.

$$t \geq 1000 \quad (1)$$

$$w \div t \leq 0.028 \quad (2)$$

$$s \div t \leq 0.028 \quad (3)$$

The maximum thickness (length in Z direction) t (nm) of the resist R is determined based on a product to be manufactured. Thus, when the auxiliary patterns 21 and the intervals 22 of the original 2 are set so as to satisfy the above-described inequalities with the maximum thickness (length in Z direction) t (nm) of the resist R as a reference, it is possible to further suppress irregularities on the inclined surfaces of the sidewall portions of the resist R.

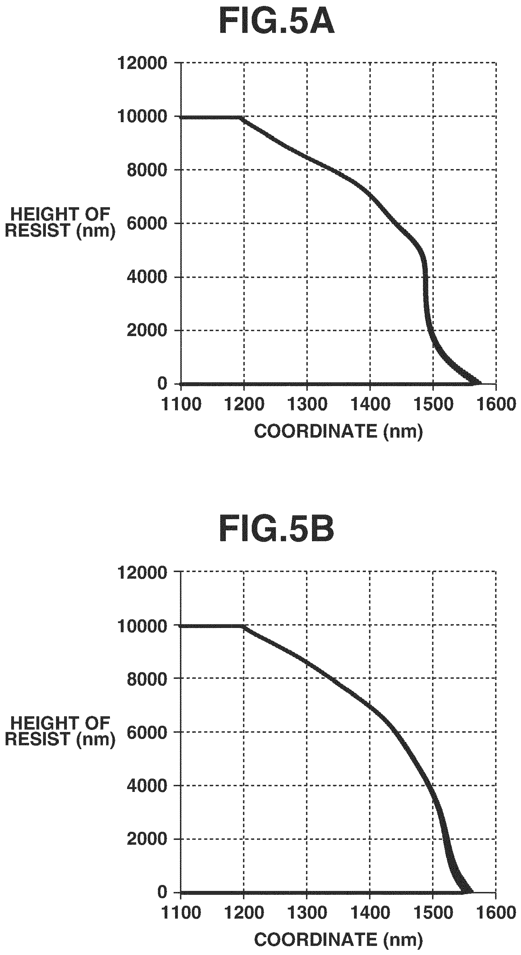

Figs. 5A and 5B each illustrate a simulation result of an inclined surface of each sidewall portion of the resist R. Fig. 5A illustrates a simulation result of the inclined surface of the sidewall portion of the resist R when exposure was performed using an original that does not include the auxiliary patterns 21 but includes only the main pattern 20. Fig. 5B illustrates a simulation result of the inclined surface of the sidewall portion of the resist R when the exposure was performed using the original 2 that includes the main pattern 20, and the auxiliary patterns 21 and the intervals 22 satisfying the inequalities (1), (2), and (3). It is clear that the irregularities can be suppressed on the inclined surface of the sidewall portion of the resist R illustrated in Fig. 5B compared with the inclined surface of the sidewall portion of the resist R illustrated in Fig. 5A.

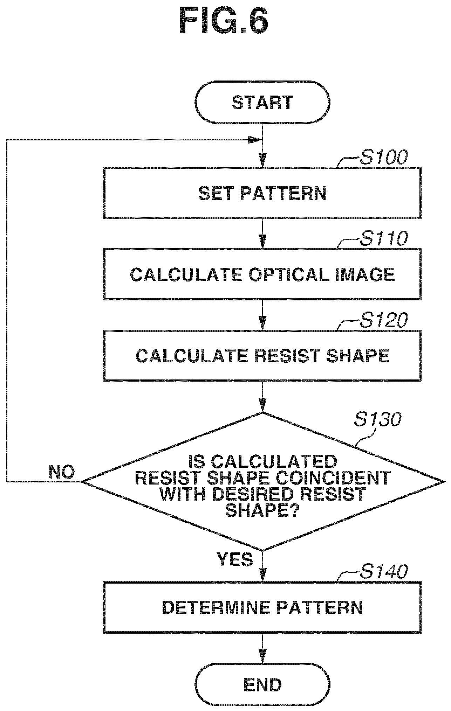

Fig. 6 is a flowchart illustrating an example of a method of determining the pattern of the original 2 according to the present exemplary embodiment. First, in step S100, the pattern of the original 2 is set. More specifically, the positions of the auxiliary patterns 21 on the original 2 are set with the position of the main pattern 20 as a reference. In the setting, the intervals 22 and the areas 23 are also set. In step S100, in addition to the positions of the auxiliary patterns 21 on the original 2, line widths and transmittances of the auxiliary patterns 21, or transmittances of the intervals 22 may be set together. When the processing in step S 100 is performed for the first time, the auxiliary patterns 21 and the intervals 22 may not be set.

Next, in step S110, an optical image is calculated. The optical image according to the present exemplary embodiment is light intensity distribution on an image plane when the original 2 is illuminated. In step S110, simulation is performed by a computer or the like based on pattern information on the original 2 (information on main pattern 20, information on auxiliary patterns 21, information on intervals 22, and information on areas 23) set in step S100, to calculate the optical image. In step S110, the optical image may be calculated based on the exposure condition in addition to the pattern information on the original 2.

Then, in step S120, a resist shape is calculated. In step S120, simulation is performed by a computer or the like based on the optical image calculated in step S110, to calculate the shape of the resist R. In step S120, the shape of the resist R may be calculated based on at least one of the exposure characteristics of the resist R and the film thickness of the resist R in addition to the optical image calculated in step S110.

Then, in step S130, it is determined whether the resist shape calculated in step S120 is coincident with a desired resist shape. The desired resist shape includes desired shapes of the inclined surfaces of the sidewall portions of the resist R. In a case where the calculated resist shape is coincident with the desired resist shape in step S130 (YES in step S130), the processing proceeds to step S140. In step S140, the pattern of the original 2 is determined. The processing then ends. In a case where the calculated resist shape is not coincident with the desired resist shape in step S130 (NO in step S130), the processing returns to step S100. In step S100, the pattern of the original 2 is set again. In step S110, the optical image is calculated again. Note that the pattern of the original 2 may not be determined by the method illustrated in Fig. 6, and not all of the information used in the flowchart in Fig. 6 may be used, as long as the pattern of the original 2 that enables formation of the desired shapes of the inclined surfaces of the sidewall portions of the resist R can be determined. In step S130, when the resist shape calculated in step S120 is not coincident with the desired resist shape but is within a range of a shape deviation amount predetermined by the user, it may be determined that the calculated resist shape is coincident with the desired resist shape.

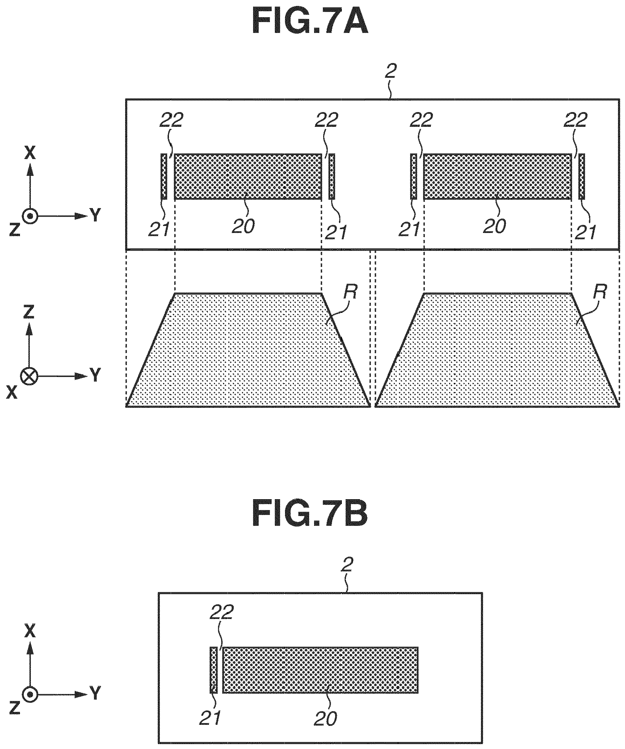

In the present exemplary embodiment, the example in which one main pattern 20 is provided on the original 2 is described; however, the number of main patterns provided on the original 2 is not particularly limited. Figs. 7A and 7B each illustrate another example of the original 2 according to the present exemplary embodiment. For example, as illustrated in Fig. 7A, two main patterns 20 may be provided on the original 2, and the auxiliary patterns 21 may be provided on both sides of each of the main patterns 20. Alternatively, as illustrated in Fig. 7B, the auxiliary pattern 21 may be provided not on both sides but on one side of the main pattern 20. Further, in the present exemplary embodiment, the example in which the auxiliary patterns 21 are provided at the positions in the Y direction of the main pattern 20 is described; however, the auxiliary patterns 21 may be provided at positions in the X direction of the main pattern 20.

As described above, the original 2 according to the present exemplary embodiment includes the auxiliary patterns 21 for suppressing irregularities on the inclined surfaces of the sidewall portions of the resist R, which makes it possible to suppress irregularities on the inclined surfaces of the sidewall portions of the resist R. As a result, in a case where the stepped shape is formed in the multilayer film L by using the resist R exposed using the original 2, it is possible to suppress the difference in the step surface widths of the steps of the stepped shape.

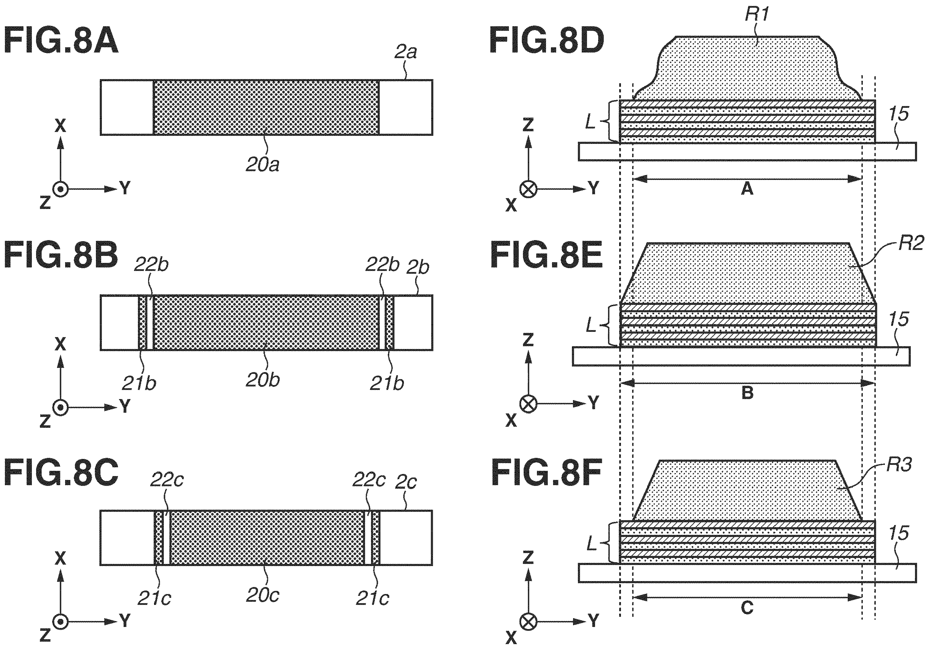

Figs. 8A to 8F illustrate examples of a pattern of an original and a resist shape according to a second exemplary embodiment. Fig. 8A illustrates an original 2a that includes a main pattern 20a but includes no auxiliary pattern. Fig. 8D is a schematic view illustrating a shape of the resist R in a case where exposure is performed using the original 2a. Fig. 8B illustrates an original 2b that includes a main pattern 20b and auxiliary patterns 21b. An interval 22b is provided between the main pattern 20b and each of the auxiliary patterns 21b. Fig. 8E is a schematic view illustrating a shape of the resist R in a case where exposure is performed using the original 2b. Fig. 8C illustrates an original 2c that includes a main pattern 20c and auxiliary patterns 21c. An interval 22c is provided between the main pattern 20c and each of the auxiliary patterns 21c. Fig. 8F is a schematic view illustrating a shape of the resist R in a case where exposure is performed using the original 2c.

A contact length A of a resist R1 with the multilayer film L illustrated in Fig. 8D in the case where the exposure is performed using the original 2a illustrated in Fig. 8A is different from a contact length B of a resist R2 with the multilayer film L illustrated in Fig. 8E in the case where the exposure is performed using the original 2b illustrated in Fig. 8B. This is because providing the auxiliary patterns 21b increases the length of the resist R2 in the Y direction corresponding to the main pattern 20b.

In the present exemplary embodiment, as illustrated in Fig. 8C, the original 2c including the main pattern 20c in consideration of change in size (based on change in size) of the resist (resist image) caused by provision of the auxiliary patterns 21c is used. As a result, the contact length A of the resist R1 with the multilayer film L illustrated in Fig. 8D in the case where the exposure is performed using the original 2a illustrated in Fig. 8A becomes equal to a contact length C of a resist R3 with the multilayer film L illustrated in Fig. 8F in the case where the exposure is performed using the original 2c illustrated in Fig. 8C. Accordingly, even when the auxiliary patterns 21 are provided, the main pattern 20 having the desired size can be formed on the resist R.

In a third exemplary embodiment, an article is manufactured using the above-described original.

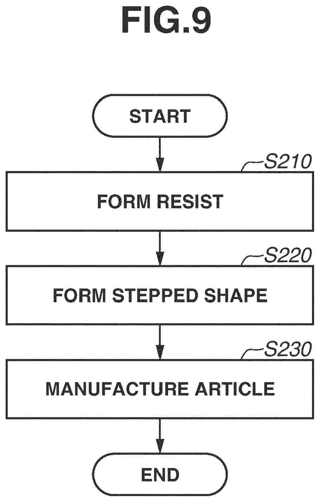

Fig. 9 is a flowchart illustrating a method of manufacturing an article according to the present exemplary embodiment. In step S210, the resist R having the inclined sidewall portions is formed on the multilayer film L provided on the substrate 15 by using the above-described original. The original used in step S210 includes the main pattern 20, and the auxiliary patterns 21 disposed at the positions each separated by the interval 22 (predetermined interval) from the main pattern 20. The irregularities of the sidewall portions of the resist R formed in step S210 are suppressed by the auxiliary patterns 21.

Next, in step S220, a stepped shape is formed in the multilayer film L on the substrate 15 by using the resist R formed in step S210. In step S230, an article is manufactured from the substrate 15 obtained by forming the stepped shape in the multilayer film L in step S220.

Examples of the article manufactured by the manufacturing method include a semiconductor integrated circuit (IC) device, a liquid crystal display device, a color filter, and a microelectromechanical system (MEMS).

In step S220, the stepped shape is formed in the multilayer film L by, for example, alternately repeating etching of the multilayer film L and reduction of the width of the resist R. According to the manufacturing method, it is possible to manufacture an article with high quality as compared with the existing manufacturing method.

The present invention is not limited to the above-described exemplary embodiments, and can be variously changed and modified without departing from the scope of the invention. Therefore, the claims are appended to make public the scope of the present invention.

According to the exemplary embodiments, it is possible to provide the original that can suppress irregularities on the inclined surfaces of the sidewall portions of the resist used for forming the stepped shape in the multilayer film.

While the present invention has been described with reference to exemplary embodiments, it is to be understood that the invention is not limited to the disclosed exemplary embodiments. The scope of the following claims is to be accorded the broadest interpretation so as to encompass all equivalent structures and functions.

The following claim-like "clauses" form part of the description. The claims follow the description and are labelled accordingly.

CLAUSES

1. An original including a pattern formed for use in exposure of a photosensitive material disposed on an upper side of a multilayer film provided on a substrate,

> wherein the pattern includes a main pattern and an auxiliary pattern disposed at a position separated by a predetermined interval from the main pattern, and
> wherein the auxiliary pattern suppresses irregularities on an inclined surface of a sidewall portion of the photosensitive material on which the main pattern is formed.

2. The original according to clause 1, wherein the auxiliary pattern is provided at the position based on information on the main pattern and information on the desired inclined surface.

3. The original according to clause 2, wherein the auxiliary pattern is provided at the position based on at least one of an exposure condition, exposure characteristics of the photosensitive material, and a film thickness of the photosensitive material.

4. The original according to any one of clauses 1 to 3, wherein a width of the predetermined interval is 2.8% or less of a maximum thickness of the photosensitive material.

5. The original according to any one of clauses 1 to 4, wherein a width of the auxiliary pattern is 2.8% or less of a maximum thickness of the photosensitive material.

6. The original according to any one of clauses 1 to 5, wherein the auxiliary pattern is provided on each of both sides of the main pattern.

7. The original according to any one of clauses 1 to 6, wherein the main pattern is provided based on change in size of the photosensitive material caused by provision of the auxiliary pattern.

8. An original including a pattern formed for use in exposure of a photosensitive material disposed on an upper side of a multilayer film provided on a substrate,

> wherein the pattern includes a main pattern and an auxiliary pattern disposed at a position separated by a predetermined interval from the main pattern, and
> wherein a width of the predetermined interval is 2.8% or less of a maximum thickness of the photosensitive material.

9. An original including a pattern formed for use in exposure of a photosensitive material disposed on an upper side of a multilayer film provided on a substrate,

> wherein the pattern includes a main pattern and an auxiliary pattern disposed at a position separated by a predetermined interval from the main pattern, and

wherein a width of the auxiliary pattern is 2.8% or less of a maximum thickness of the photosensitive material.

10. A method of determining a pattern of an original for use in exposure of a photosensitive material provided on a substrate, the method comprising:

calculating a shape of the photosensitive material in a case where an original including a main pattern and an auxiliary pattern are used, the auxiliary pattern being disposed at a position separated by a predetermined interval from the main pattern; and
determining a pattern of the original based on a calculated shape of the photosensitive material.

11. The method according to clause 10, further comprising determining whether the calculated shape of the photosensitive material is coincident with a desired shape of the photosensitive material,

wherein, in a case where the calculated shape of the photosensitive material is coincident with the desired shape of the photosensitive material, the pattern of the original is determined, and
wherein, in a case where the calculated shape of the photosensitive material is not coincident with the desired shape of the photosensitive material, the shape of the photosensitive material is calculated again.

12. A method of exposing a photosensitive material disposed on an upper side of a multilayer film provided on a substrate, the method comprising performing exposure using an original that includes a main pattern and an auxiliary pattern disposed at a position separated by a predetermined interval from the main pattern,
wherein the auxiliary pattern suppresses irregularities on an inclined surface of a sidewall portion of the photosensitive material on which the main pattern is formed by performing the exposure.
13. A method of manufacturing an article, the method comprising:

forming a photosensitive material including an inclined sidewall portion, on an upper side of a multilayer film provided on a substrate, by using an original;
forming a stepped shape in the multilayer film provided on the substrate by using the formed photosensitive material; and
manufacturing an article from the substrate having the stepped shape in the multilayer film, wherein the original for use in forming the photosensitive material includes a main pattern and an auxiliary pattern disposed at a position separated by a predetermined interval from the main pattern, and
wherein a width of the predetermined interval is 2.8% or less of a maximum thickness of the photosensitive material.

14. The method according to clause 13, wherein the stepped shape is formed by alternately repeating etching of the multilayer film and reduction of a width of the photosensitive material.
15. The method according to clause 13 or 14, wherein a step surface width of each step of the formed stepped shape is within a range set by a user.

**Claims**

1. An original including a pattern formed for use in exposure of a photosensitive material disposed on an upper side of a multilayer film provided on a substrate,

wherein the pattern includes a main pattern and an auxiliary pattern disposed at a position separated by a predetermined interval from the main pattern, and
wherein the auxiliary pattern suppresses irregularities on an inclined surface of a sidewall portion of the photosensitive material on which the main pattern is formed.

2. The original according to claim 1, wherein the auxiliary pattern is provided at the position based on information on the main pattern and information on the desired inclined surface.

3. The original according to claim 2, wherein the auxiliary pattern is provided at the position based on at least one of an exposure condition, exposure characteristics of the photosensitive material, and a film thickness of the photosensitive material.

4. The original according to any preceding claim, wherein a width of the predetermined interval is 2.8% or less of a maximum thickness of the photosensitive material.

5. The original according to any preceding claim, wherein a width of the auxiliary pattern is 2.8% or less of a maximum thickness of the photosensitive material.

6. The original according to any preceding claim, wherein the auxiliary pattern is provided on each of both sides of the main pattern.

7. The original according to any preceding claim, wherein the main pattern is provided based on change in size of the photosensitive material caused by provision of the auxiliary pattern.

8. A method of determining a pattern of an original for use in exposure of a photosensitive material provided on a substrate, the method comprising:

   calculating a shape of the photosensitive material in a case where an original including a main pattern and an auxiliary pattern are used, the auxiliary pattern being disposed at a position separated by a predetermined interval from the main pattern; and
   determining a pattern of the original based on a calculated shape of the photosensitive material.

9. The method according to claim 8, further comprising determining whether the calculated shape of the photosensitive material is coincident with a desired shape of the photosensitive material,

   wherein, in a case where the calculated shape of the photosensitive material is coincident with the desired shape of the photosensitive material, the pattern of the original is determined, and
   wherein, in a case where the calculated shape of the photosensitive material is not coincident with the desired shape of the photosensitive material, the shape of the photosensitive material is calculated again.

10. A method of exposing a photosensitive material disposed on an upper side of a multilayer film provided on a substrate, the method comprising performing exposure using an original that includes a main pattern and an auxiliary pattern disposed at a position separated by a predetermined interval from the main pattern,
    wherein the auxiliary pattern suppresses irregularities on an inclined surface of a sidewall portion of the photosensitive material on which the main pattern is formed by performing the exposure.

# FIG.1

**FIG.2A**

**FIG.2B**

**FIG.2C**

**FIG.2D**

**FIG.2E**

**FIG.2F**

FIG.3A

FIG.3B

FIG.3C

FIG.3D

FIG.3E

FIG.3F

# FIG.4

# FIG.5A

# FIG.5B

# FIG.6

```
        ( START )
            |
            v
    ┌───────────────────────┐  ─S100
    │     SET PATTERN        │
    └───────────────────────┘
            |
            v
    ┌───────────────────────┐  ─S110
    │ CALCULATE OPTICAL IMAGE│
    └───────────────────────┘
            |
            v
    ┌───────────────────────┐  ─S120
    │ CALCULATE RESIST SHAPE │
    └───────────────────────┘
            |
            v
            /\                        S130
           /  \
    NO    / IS CALCULATED \
   <─────< RESIST SHAPE COINCIDENT >
          \ WITH DESIRED RESIST /
           \    SHAPE?    /
            \    /
             \  /
          YES \/
            |
            v
    ┌───────────────────────┐  ─S140
    │   DETERMINE PATTERN    │
    └───────────────────────┘
            |
            v
        (  END  )
```

# FIG.7A

# FIG.7B

FIG.8A

2a
20a

FIG.8B

22b 2b
21b
22b
20b
21b

FIG.8C

22c 2c
21c
22c
20c
21c

FIG.8D

R1
15
A
L

FIG.8E

R2
15
B
L

FIG.8F

R3
15
C
L

16

# FIG.9

```
        ┌─────────────┐
        │    START    │
        └─────────────┘
               │
               ▼            ⟋S210
  ┌──────────────────────────┐
  │       FORM RESIST        │
  └──────────────────────────┘
               │
               ▼            ⟋S220
  ┌──────────────────────────┐
  │    FORM STEPPED SHAPE    │
  └──────────────────────────┘
               │
               ▼            ⟋S230
  ┌──────────────────────────┐
  │   MANUFACTURE ARTICLE    │
  └──────────────────────────┘
               │
               ▼
        ┌─────────────┐
        │     END     │
        └─────────────┘
```

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014036148 A